# EUROPEAN PATENT APPLICATION

(11) **EP 1 471 409 A1**
(43) Date of publication of application: **27.10.2004**
(21) Application number: 03009202.7
(22) Date of filing: 22.04.2003
(51) Int. Cl.: G06F 1/20

(54) **Water cooled heat dissipation device**

(71) Applicant: Pentalpha International Inc., Hsin Tien City, Taipei (TW)
(72) Inventor: Liu, Chen-Yu, Hsin Tien City, Taipei (TW)
(74) Representative: Jentschura, Rolf, Dipl.-Ing.

(57) **Abstract**

A kind of water cooled device is combined by a water tank (2) with heat dissipation unit (3) mainly and put a pumping motor into the water tank. There set a water filling hole (21) water outlet hole (25) and water inlet hole (24) on the water tank. The water outlet hole and water inlet hole connect with one end part of a water outlet pipe (8) and water inlet pipe (9) individually. And the other end part of water outlet pipe and water inlet pipe connect with a heat dissipation unit (6). The heat dissipation unit (6) tie up on CPU and set a water channel (61) in the interior to make the cooling water on the water tank can discharge from the water outlet pipe by the pumping of pumping motor. And then flow back to the water tank by water inlet pipe and by the water channel on interior of heat dissipation unit to form a loop and to achieve the effect of CPU heat dissipation. Covering a top cover (4) on the base (1) to envelop the water tank and heat dissipation unit on the top cover to form a box cast. The box cast can insert in the 5 1/4 inch and 3 1/2 inch driver bay on the computer case front panel to achieve the purpose of saving space.

## Description

### BACKGROUND OF THE INVENTION

### 1. Field of the invention

This invention is about a kind of water cooled device, especially refer to a type of water cooled device which can insert in the driver bay on the computer case front panel to save used space.

### 2. DESCRIPTION OF THE PRIOR ART

The conventional used CPU water cooled system, please refer to our country's announcement number 458317 [improvement of CPU water cooled system] ( below called cite as evidence case ). The cite as evidence case is combined principally by a base and a top cover, therein set a water channel on the base. And on the exterior of the heat dissipation device form a water inlet hole and a water outlet hole on two ends of the water channel individually and symmetrically. The cooling fluid can pour into the water channel by the water inlet hole. Absorbing the heat source on the base and top cover by water channel then flow out by the water outlet hole to achieve the purpose of heat dissipation cyclically. The feature is : On the circumference of the base set through a drowned orifice hole individually; setting the water inlet-outlet hole on the top cover perpendicularly to make the axis of the water inlet-outlet hole being perpendicular to the flow direction of the cooling fluid. And on the opposite side of the drowned orifice hole on the base will set a drowned orifice hole on the top cover too. It will provide a fastening bolt to set through the drowned orifice holes of the top cover and base then press tightly and block to fix.

Nevertheless, although the cite as evidence case can achieve the purpose of water cooling and heat dissipation, but it must mount a container which fill with cooling fluid around the computer main set, and then can transport cooling water to the radiator. It has the defect of occupying space in practical use. And the container is apart from the computer main set. It is not convenient for practical use. When the container overturn will cause the radiator to lose the effect of heat dissipation, and the cooling water is very possible to impregnate into the computer main set to cause the damage of the main set.

From this can see, the conventional used object mentioned above still has many defects, it's not a good design actually and need wait to improve.

The inventor of this case saw the every defects produced by the above mentioned conventional used water cooled radiator, so with grate mind to improve and create, and research alone and hardly for many year, he finally invent this water cooled device completely and successively.

### SUMMARY OF THE INVENTION

The purpose of this invention is to provide a kind of water cooled device which insert and mount the radiator in the 5 1/4 inch and 3 1/2 inch driver bay on the computer case front panel to achieve the purpose of pleasing to the eye-mounting convenient and saving space.

The next purpose of this invention is to provide a kind of water cooled device which can discharge heat energy produced in the computer main set to achieve extending the used life of the main set.

Another purpose of this invention is to provide a kind of water cooled device with many merits such as simple manufacture convenient to use and easy to mount etc.

The water cooled device which can achieve the invention purpose mentioned above includes a base-top cover-water-tank-heat dissipation components, heat dissipation unit-water inlet pipe and water outlet pipe. Therein, set a water filling hole-water inlet hole and water outlet hole on the water tank and put a pumping motor inside. The heat dissipation unit include a radiator and one or more heat dissipation fans. The heat dissipation fan is fixed and on the top of radiator. Setting a water inlet hole and water outlet hole on the heat dissipation unit, therein mount a water channel which lead through the water inlet hole and water outlet hole each other. Join the water tank and heat dissipation unit on the base and connect an end part of the water inlet pipe and water outlet pipe with the water inlet hole and water outlet hole on the water tank individually. And the other end part connects with the water outlet hole and water inlet hole on the heat dissipation unit. The top cover combines with the base to form a box cast. The water tank and heat dissipation unit put in the box cast. And combine a heat dissipation panel on one side of the water tank. The scatter heat panel is relative to the heat dissipation unit to discharge the heat air. When operating, tie up the heat dissipation unit on the top plane of CPU, and insert the box cast in the 5 1/4 inch and 3 1/2 inch driver bay on the computer case front panel. The cooling water can be pumped by the pumping motor and flow into the water channel of the heat dissipation unit by the water outlet pipe and flow back to water tank by the water channel on the heat dissipation unit water inlet pipe to form a loop and bring back the heat energy on the heat dissipation unit to the water tank to achieve the purpose of CPU heat dissipation.

### BRIEF DESCRIPTION OF THE DRAWINGS

The drawings disclose an illustrative embodiment of the present invention which serves to exemplify the various advantages and objects hereof, and are as follows:
Fig. 1 A-B-C are the combined and indicated drawings of water cooled device of this invention; and
Fig. 2 is the practice and indicated drawing of this water cooled device.

### DETAILED DESCRIPTION OF THE PREFERRED EMBODIMENT

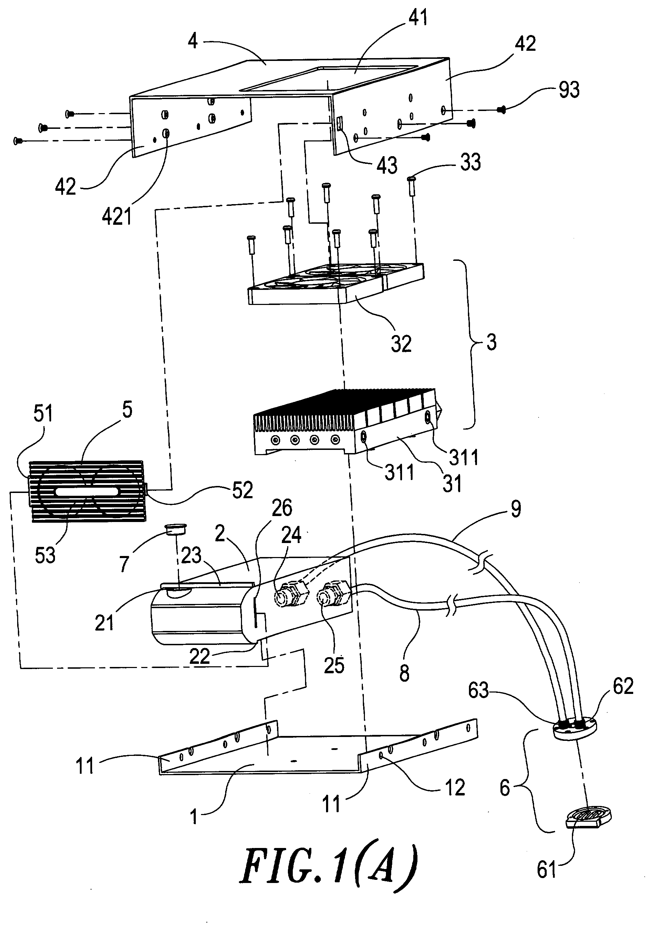

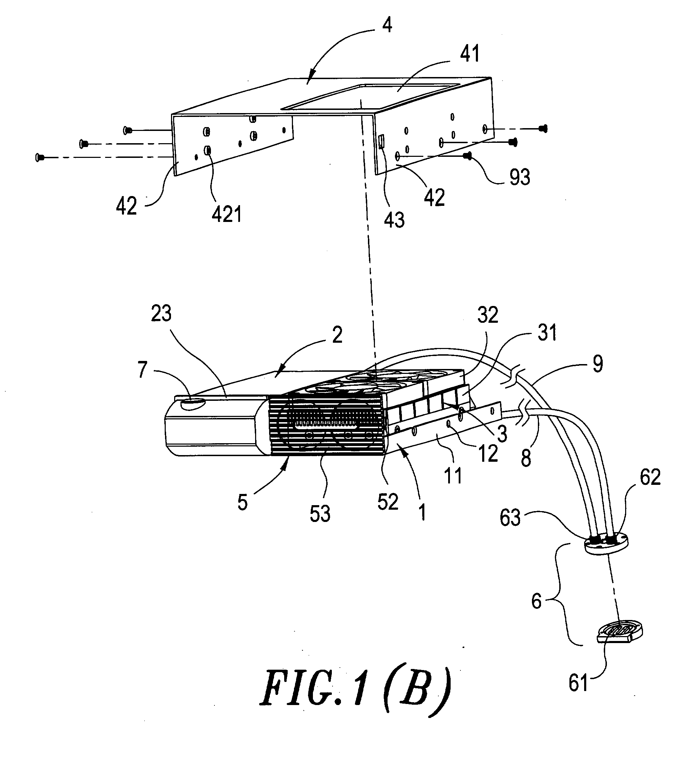

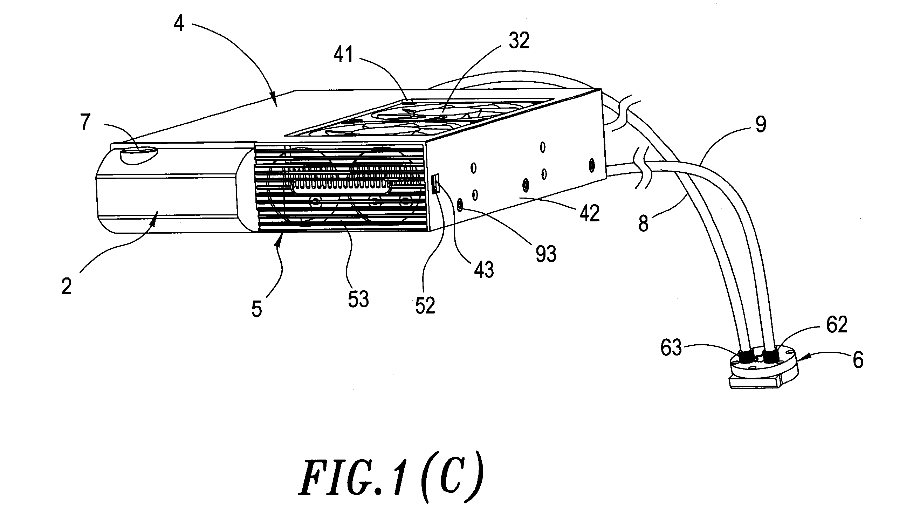

Please refer to Fig.1 A-B-C, the water cooled device provided by this invention, include mainly:

A base 1, on the two sides of the base 1 extend perpendicularly with a check plate 11, there set at least one circular hole 12 on the check plate 11.

A water tank 2, therein mount a pumping motor ( do not show in the drawing ), and in the front edge of the water tank 2 set a water filling hole 21, on the water filling hole 21 combined with a stop water bolt 7 to avoid the cooling water penetrating from the water tank 2, and on the up-down two sides of the front end extend a up-down division plate 23-22 individually, and on one of the side part set a plug groove 26, and on the rear end part set a water inlet hole 24 and a water outlet hole 25;

A heat dissipation unit 3 includes a radiator 31 and a scatter heat fan 32. The scatter heat fan is locked and fixed on the top end part of the radiator 31 by screw 33. And set a tap hole 311 on one side of the radiator 31;

A heat dissipation unit 6, therein set a water channel 61 on the heat dissipation unit 6, and relative to the two end part of the water channel 61 set a water inlet hole 62 and a water outlet hole 63 to connect water inlet hole 62 with water outlet hole 63;

A water outlet pipe 8, one end part of the water outlet pipe 8 connects with water inlet hole 62 of heat dissipation unit 6, the other one end part connects with water outlet hole 25 of the water tank 2;

A water inlet pipe 9, one end part of the water inlet pipe 9 connects with water outlet hole 63 of the heat dissipation unit 6, the other end connects with water inlet hole 24 of the water tank 2;

A heat dissipation panel 5, one side of the heat dissipation panel 5 set a plug plate 51, relative to the other side set a fastener 52, and thereon set many transverse open slot 53;

A top cover 4, set a rip 41 on the top of the top cover 4, and both of two sides extend downward and perpendicularly with a cover plate 42, on the cover plate 42 set many hollow columns 421 which extend to the interior, and therein set a pinch groove 43 on the cover plate 42;

Connect water tank 2 with heat dissipation unit 3 on the base 1, the low division plate 22 on the front end of the water tank 2 will against with the edge of the base 1, and the tap hole 311 on one side of the radiator 31 will relative to the circular hole 12 of the check plate 11 on the base 1, and connect top cover 4 with base 1 to make the hollow convex columns 421 on the two sides cover plate 42 of the top cover 4 to penetrate the check plate circular hole 12 on the base 1, penetrate the hollow convex columns 421 and circular hole 12 by lock and fixed piece 93 and locked and fixed on the tap hole 311 of the radiator 31 to connect the top cover 4 base 1 and radiator 3 stably lead the top cover 4 and base 1 to form a box cast; the up division plate 23 on the front end of the water tank 2 will against with the edge of the top cover 4, and the rip on the top cover 4 will relative to the heat dissipation fan 32 of the heat dissipation unit 3 to discharge the heat source on the heat dissipation unit 3 from the rip 41 on the top cover; and put one end plug plate 51 of the heat dissipation panel 5 into the plug groove 26 on one side of the water tank 2, and the fastener 52 on the other end tie up the cover plate pinch groove 43 on the top cover 4 to make the heat dissipation panel 5 connect with one side of the water tank 2 and relative to heat dissipation unit 3 to make the heat energy absorb from heat dissipation unit 3 can discharge from the transverse open slot 53 on the heat dissipation division plate 5.

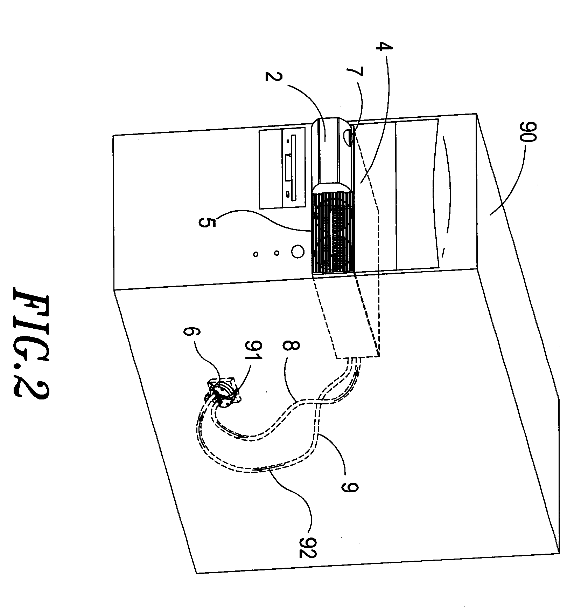

Please refer to fig.2 that is the practice view of water cooled device provided by this invention, which insert the box cast that combined top cover 4 with base 1 into the driver bay on the computer case front 90 panel. The driver bay include two sizes, one is 5 1/4 inch of width 146mm height 42mm, the other is 3 1/2 inch of width 103.5mm height 22mm. Two kind of driver bay on the PC case front panel mentioned above both cover in the protection area of this case. The heat dissipation unit 6 is close tie up CPU by a fastener 91. When operate, the user can pour cooling water 92 by the water filling hole 21 on water tank. The cooling water 92 will flow to the water channel 61 on the heat dissipation unit 6 by the water outlet hole 25 on the water tank 2-water outlet pipe 8 when pumping motor work. Then take away the CPU heat energy which is absorbed by the heat dissipation unit 6 to achieve the purpose of CPU heat dissipation. And the heat energy which had been taken away will flow back to water tank 2 by the water outlet hole 63 on heat dissipation unit 6-water inlet pipe 9-water inlet hole 24 on water tank 2 to form a loop. The heat source which was brought back by the cooling water 92 will discharge the heat energy again by the heat dissipation unit 3 on box cast. So, it will get very good effect of heat dissipation by recycle continually.

The water cooled device which is provided by this invention compares with the technique used conventionally with the advantages below:
1. This invention insert the box cast which was combined by top cover and base into the 5 1/4 inch and 3 1/2 inch driver bay on the computer case front panel. It can save the used space except from achieving the effect of pleasing to the eye and convenient to mount.
2. This invention is a kind of water cooled device can discharge the heat energy which was produced by the computer to achieve extending the used life of main set.
3. This invention with many advantages such as manufacture simple used conveniently and assemble easy etc.
Many changes and modifications in the above described embodiment of the invention can, of course, be carried out without departing from the scope thereof. Accordingly, to promote the progress in science and the useful arts, the invention is disclosed and intended to be limited only by the scope of the appended claims.

## Claims

1. A kind of water cooled device comprising at least:
a base 1, therein a check plate 11 which is extended perpendicularly on the two sides individually, set at least one circular hole 12 on said check plate 11;
a water tank 2, thereon set a water filling hole 21-water inlet hole 24 and water outlet hole 25, and set a plug groove 26 on one side part, and therein putting a pumping motor; that being combined said water tank 2 with said base 1;
a heat dissipation unit 3, there setting at least one tap hole 311 on one lateral plane of said heat dissipation unit 3; combining said heat dissipation unit 3 on said base 1 making alignment with said water tank 2 and said tap hole 311 on one side of said heat dissipation unit 3 relating to a check plate 11 circular hole 12 on said base 1;
a heat dissipation unit 6, therein setting a water way 61, and being relative to the two end part of said water way 61 setting a water inlet hole 62 and a water outlet hole 63 making said water inlet hole 62 connecting with said water outlet hole 63;
a water outlet tube 8, it's one end part connecting with said water inlet hole 62 on said heat dissipation unit 6, the other end part connecting with said water outlet hole 25 on said water tank 2;
a water inlet pipe 9, it's one end part connecting with said water outlet hole 63 on said heat dissipation unit 6, another one end connecting with said water inlet hole 24 on said water tank 2;
a top cover 4, therein setting a rip 41 on the top end part, and on the two sides both extending downward and perpendicularly with a cover plate 42, on the cover plate 42 setting many hollow columns 421 which extend to interior, and one of the cover plate 42 setting a pinch groove 43 ; connecting said top cover 4 with base 1 forming a box cast making hollow convex column 421 of said cover plate 42 on two sides of said top cover 4 penetrating into the circular hole 12 of said check plate 11 on said base 1, penetrating said circular hole 12 by lock and fixed piece 93 and locking and fixing on the tap hole 311 of said heat dissipation unit 3, making said top cover 4-said base 1 and said heat dissipation unit 3 connected stably;
a heat dissipation panel 5, one side of it setting a plug plate 51, being relative to the other side setting a fastener 52, and setting many transverse open slot 53 on it; putting said plug plate 51 of said heat dissipation panel 5 into said plug groove 26 on one side of said water tank 2, and said fastener 52 on the other end tie up said pinch groove 43 of said cover plate 42 on said top cover 4 making said heat dissipation panel 5 connecting with one side of said water tank 2 stably;
putting the box cast which is combined said top cover 4 with base 1 into the 5 1/4 inch and 3 1/2 inch driver bay on a computer case front panel, and said heat dissipation unit tie up on CPU, pumping cooling water 92 by a pumping motor on said water tank 2 making the cooling water 92 flowing through a water channel 61 on said heat dissipation unit 6 and then flowing back to said water tank 2, taking away the heat energy on said heat dissipation unit 6, achieving heat dissipation of CPU.

2. A water cooled device as claim 1, therein a water filling hole 21 on said water tank 2 combined with a stop water bolt 7, avoiding cooling water 92 on said water tank 2 penetrating.

3. A water cooled device as claim 1, therein said heat dissipation unit 3 including a radiator 31 and a heat dissipation fan 32, said heat dissipation fan 32 fixed and connected on the top end part of said radiator 31.

4. A water cooled device as claim 1, therein the front end of said water tank 2 extending with a up-down division plate 23-22, said up-down division plate 23-22 being against with the edge of said top cover 4 and said base 1.

5. A water cooled device as claim 1, therein said heat dissipation division plate 5 being relative to said heat dissipation unit 3, making the heat energy on heat dissipation unit 3 discharging from the transverse open slot 53 on heat dissipation division plate 5.

6. A water cooled device as claim 1, therein said heat dissipation fan 32 on said heat dissipation unit 3 being relative to the rip 41 on said top cover 4, making the heat energy on heat dissipation unit 3 discharging by the rip 41.
